# EUROPÄISCHE PATENTANMELDUNG

(11) **EP 1 278 243 A2**
(43) Veröffentlichungstag der Anmeldung: **22.01.2003**
(21) Anmeldenummer: 02090261.5
(22) Anmeldetag: 17.07.2002
(51) Int. Cl.: H01L 25/065

(54) **Multichipmodul in COB Bauweise, insbesondere Compact Flash Card mit hoher Speicherkapazität und Verfahren zur Herstellung desselben**

(30) Priorität: 20.07.2001 DE 10136655
(71) Anmelder: Optosys Technologies GmbH, 12681 Berlin (DE)
(72) Erfinder: Prietzsch, Dieter, 12559 Berlin (DE)
(74) Vertreter: Riemann, Bernd

(57) **Zusammenfassung**

Die Erfindung bezieht sich auf die Bereitstellung von Modulen in COB Bauweise mit Halbleiterchips, insbesondere nichtflüchtigen Speicherchips deren Bondpads peripher angeordnet sind und die eine hohe Speicherkapazität aufweisen sowie auf ein Verfahren zur Montage desselben.

Aufgabe der Erfindung ist es, unter Ausnutzung der geometrischen Voraussetzungen und bei Einhaltung der geforderten Bauhöhe ein Modul mit Halbleiterchips, insbesondere mit nichtflüchtigen Speicherchips in COB Bauweise mit hoher Funktionalität, insbesondere mit maximaler Speicherkapazität bereitzustellen sowie ein Montageverfahren hierzu anzugeben.

Diese Aufgabe ist durch das Modul im wesentlichen dadurch gelöst, dass die als Nacktchips ausgebildeten Chips (3) auf dem Board (1) in Sandwichform nicht direkt übereinanderliegend angeordnet sind. Verfahrensseitig ist vorgesehen, dass die als Nacktchips ausgebildeten Chips lagenweise montiert werden.
Die Zeichnung zeigt das Multichipmodul in einem Vertikalschnitt.

## Beschreibung

Die Erfindung bezieht sich auf die Bereitstellung von Modulen in COB Bauweise mit Halbleiterchips, insbesondere nichtflüchtigen Speicherchips deren Bondpads peripher angeordnet sind und die eine hohe Speicherkapazität aufweisen sowie auf ein Verfahren zur Montage desselben.

Durch die DE 197 28 953 A1 ist ein Verfahren und eine Anordnung zur Herstellung eines Multi-Chip Modules bekannt geworden. Verfahrensseitig ist vorgesehen, dass die Chips in einem definierten Raster auf dem Leiterplattenboard aufgebracht werden, anschliessend das Bonden auf der gleichen Seite durchgeführt wird, danach die Abdeckung der Chips so erfolgt, dass in einem ersten Verfahrensschritt ein dünnflüssiges Epoxidharz in den als Abstand (b) vorhandenen Freiraum zwischen den Chips eingebracht wird. Danach erfolgt längsseits zwischen den Zeilen mindestens ein linienförmiger Masseeintrag. Anschliessend werden die Ventile der Masseeintragsvorrichtung geschlossen, wobei die Vorrichtung an den Anfangspunkt des Moduls zurückfährt. In einem sich anschliessenden weiteren Verfahrensschritt wird ein erster Ring um den äusseren Umfang des Chipbereiches gelegt. Nach diesem ersten Ring wird ein zweiter Ring in definiertem Abstand gelegt und in einem nächsten Verfahrensschritt wird von der Aussenkante der Schmalseite des Moduls mäanderfömig Vergussmasse in Richtung der gegenüber sich befindlichen Aussenkante aufgetragen.
Anordnungsseitig ist vorgesehen, dass die Chips auf dem Leiterplattenboard beidseitig in gleicher Stückzahl in einem festgelegten Raster angeordnet sind.

Durch die DE 197 47 177 A1 ist ein gehäustes Bauelement, insbesondere ein stapelbares, gehäustes elektronisches Bauelement und ein Verfahren zur Herstellung desselben bekannt geworden. Dieses Bauelement ist charakterisiert durch ein Substrat mit einem ersten Bereich, einem zweiten Bereich und einem flexiblen Bereich und zumindest einem Bauelement, welches auf dem ersten Bereich des Substrates angeordnet und kontaktiert ist. Dabei ist der flexible Bereich des Substrates derart verbogen, dass der erste Bereich und der zweite Bereich des Substrates geklappt sind, so dass der erste Bereich und der zweite Bereich im wesentlichen einander gegenüberliegend angeordnet sind und das zumindest eine Bauelement einschließen. Dabei sind die Anschlußleitungen des zumindest einen Bauelementes auf eine Hauptoberfläche des ersten und / oder zweiten Bereichs, die im geklappten Zustand des Substrates außen liegt, herausgeführt.

Des weiteren ist durch die DE 197 25 464 A1 ein Halbleiterchip ― Stapelgehäuse und ein Verfahren zu dessen Herstellung bekannt geworden. Das Halbleiterchip ― Stapelgehäuse, das eine Vielzahl von Halbleiterchips mit einer Vielzahl von auf jeder oberen Oberfläche von diesen geformten Chip - anschlußfeldern einschließt, enthält: eine Vielzahl von Drähten, die jeweils ein entsprechendes aus der Vielzahl von Chip - Anschlußfeldern und einen Kantenteil der entsprechenden Halbleiterchips verbinden, einen Gehäusekörper, der aus einer Vielzahl von Halbleiterchips, die nacheinander mit einem ersten Klebstoff dazwischen gestapelt sind, geformt ist, ein Kontaktband, das unter Verwendung eines zweiten Klebstoffes auf einer zweiten seitlichen Oberfläche des Gehäusekörpers angebracht ist, einen Wärmeableiter, der unter Verwendung eines dritten Klebstoffes auf jeder von unteren, oberen und ersten seitlichen Oberflächen des so aufgebauten Gehäusekörpers angebracht ist, und eine Vielzahl von Lotkugeln, die auf einer unteren Oberfläche des Kontaktbandes geformt sind. Das Stapelgehäuse erleichtert die Abgabe der durch die Halbleiterchips erzeugten Wärme nach außen und verhindert dadurch, dass sich die Gehäusezuverlässigkeit verschlechtert.
Aus der GB 2 344 217 A1 ist ein Multi-Chip-Modul bekannt, welches eine Anordnung gestapelter Halbleiter Chips umfaßt. Dabei sind Chips unterschiedlicher flächiger Abmessungen direkt übereinanderliegend angeordnet, wobei über Drahtbondung die Verbindung zu den Bondpads erfolgt.

Beim Einsatz von gehäusten Flashkomponenten in Form von TSOP oder ähnlichen Bauformen ist die Anordnung nur flächenhaft im Rahmen der geometrischen Abmessungen des Boards möglich. Dadurch ist die Speicherkapazität der Flash Card in Abhängigkeit von der eingesetzten Chipversion begrenzt.

Aufgabe der Erfindung ist es, unter Ausnutzung der geometrischen Voraussetzungen und bei Einhaltung der geforderten Bauhöhe ein Modul mit Halbleiterchips, insbesondere mit nichtflüchtigen Speicherchips in COB Bauweise mit hoher Funktionalität, insbesondere maximaler Speicherkapazität bereitzustellen sowie ein Montageverfahren hierzu anzugeben.

Die Lösung dieser Aufgabe ergibt sich aus dem kennzeichnenden Merkmal des Patentanspruches 1 sowie verfahrensseitig aus den kennzeichnenden Merkmalen des Patentanspruches 7. Die übrigen Ansprüche betreffen zweckmäßige Ausgestaltungen des Multichipmoduls inclusive des Verfahrens zur Herstellung desselben.

Sowohl durch die kontinuierliche Weiterentwicklung bei transportablen PC's, durch die rasante Entwicklung in der Mobilfunkindustrie, insbesondere aber durch die Entwicklung der digitalen Fotografie werden die Anforderungen an die Bereitstellung von Speichermodulen geprägt.

Besonders durch die Bereitstellung weiterer Funktionen im mobilen Sektor der Kommunikationsbranche entsteht die Nachfrage nach Speichermodulen mit einer hohen Speicherkapazität.

Beim Einsatz von Nacktchips (bare die's) ist es möglich, eine zusätzliche Anzahl von Chips durch eine lagenweise Anordnung der Chips zu integrieren und damit die Speicherkapazität der Flash Card weiter zu erhöhen. Es ist ebenso möglich, andere Bauelemente, wie z. B. Controller, lagenweise anzuordnen.
Die CompactFlash Card besteht aus der Kombination eines Microcontrollers und einer der vorgesehenen Kapazität entsprechenden Anzahl von Flashkomponenten, zum Beispiel Flashchips.

Die gefundene Lösung bietet die Möglichkeit, durch Ausnutzung des freien Raumes in der Z-Achse zusätzliche Chips bzw. andere Bauelemente n-fach zu plazieren und damit die Speicherkapazität bzw. die Funktionalität wesentlich zu erhöhen. Durch den Einsatz der sogenannten Nacktchips ist es beispielsweise möglich, die Chips in drei, vier oder auch mehr Ebenen übereinander in Sandwichform anzuordnen. Unter der Sandwichform ist hierbei zu verstehen, dass die Nacktchips nicht direkt übereinander gestapelt werden können. Es bedarf hierzu entsprechender technischer Maßnahmen, die insbesondere auch die Führung der Bondverbindungen berücksichtigen, so dass die Funktionsfähigkeit nicht eingeschränkt wird.

Ein zwischen den beiden Chipebenen plaziertes und in Klebefugen eingebettetes Distanzstück, welches auch in seiner Länge bestimmte Bedingungen erfüllt, schafft insbesondere im Hinblick auf die Kontaktierung die Voraussetzungen zur lagenweisen Anordnung der Chips. Zur Vermeidung von Beschädigungen der Bondverbindungen ist das Distanzstück an den Seiten, wo die Bondpads liegen, verkürzt ausgebildet.

Es liegt durchaus im Rahmen der Erfindung, die Klebefuge in einer modifizierten Art auszubilden. So ist es auch denkbar, dass der Klebstoff auch auf die Unterseite des Distanzstückes bzw. des Chips aufgetragen wird. Damit soll eine mögliche Schädigung der aktiven Strukturen des Chips verhindert werden. Die Klebefuge kann beispielsweise auch durch eine beidseitig mit Klebstoff beschichtete Folie gebildet werden.

Die zur Funktion der Flashkomponente erforderlichen Signale sind bis auf /CE alle identisch, das heißt, das entsprechende Chip wird über das zugehörige Signal /CE(n) aktiviert, wobei n der Anzahl der Chips entspricht.

Auf dem Board ist eine Kontaktierungsmatrix mit dem Ziel ausgebildet, im Funktionstest ermittelte nicht funktionsfähige Chips zu separieren.

Ein wesentlicher Vorteil der vorstehend genannten Lösung besteht darin, dass durch Nutzung der Z - Achse bei der Unterbringung von Nacktchips bzw. von anderen Bauelementen auf einem Board die Möglichkeit geschaffen wurde, die Speicherkapazität bzw. die Funktionalität bei gleicher Grundfläche wesentlich zu erhöhen.

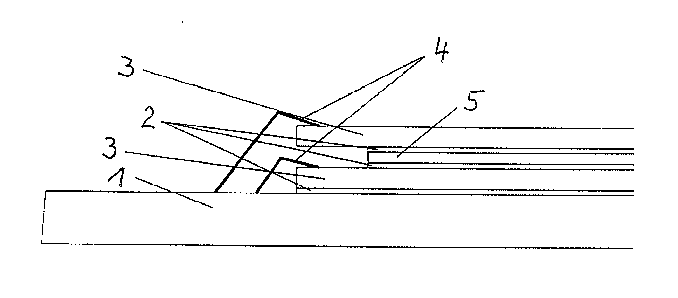

Die Erfindung soll nachstehend anhand der Zeichnung im Prinzip beispielshalber noch näher erläutert werden.

Die zugehörige Zeichnung zeigt das Multichipmodul in einem Vertikalschnitt.

Auf einem Board 1 ist im Bereich der Grundfläche des aufzubringenden Chips 3 eine Klebstofffuge 2 aufgetragen. Über einen Bonddraht 4 wird die Verbindung zu den Bondpads auf dem Board 1 in bekannter Weise hergestellt. Danach erfolgt ein funktioneller Test der aufgebrachten Chips 3 in der jeweiligen Ebene. Anschließend wird auf die Oberfläche des Chips 3 eine Klebstofffuge 2, vorzugsweise ein isolierendes thermisches Epoxy, aufgetragen. Danach wird ein Distanzstück 5 auf die Länge der aufgebrachten Klebstofffuge 2 diese abdeckend aufgebracht. Auf das Distanzstück 5 wird nunmehr im nächsten Arbeitsgang eine neue Klebstofffuge 2 zur Befestigung des Chips 3 der nächsten Chipebene ausgebildet.

Die Abmessungen der Bondpads auf dem Board sind so definiert, dass die lagenweise Wirebondung hintereinander auf dem Bondpad angeordnet ist. Nur das chipspezifische Signal /CE wird für jedes Chip separat zugeführt.

## Patentansprüche

1. Multichipmodul in COB Bauweise, insbesondere CompactFlash Card mit hoher Speicherkapazität, umfassend ein Board, einen Controller, Flashchips, pheriphere Elemente, Steckverbinder und pheripher angeordnete Bondpads, **dadurch gekennzeichnet, dass** die als Nacktchips ausgebildeten Chips (3) auf dem Board (1) in Sandwichform nicht direkt übereinanderliegend angeordnet sind.

2. Multichipmodul nach Anspruch 1, **dadurch gekennzeichnet, dass** die Sandwichform aus einem Chip (3) und aus zwei Klebstofffugen (2) mit einem zwischen den Klebstofffugen (2) liegenden Distanzstück (5) gebildet ist.

3. Multichipmodul nach Anspruch 1 oder 2, **dadurch gekennzeichnet, dass** das Distanzstück (5) an den beiden Seitenflächen, wo die Bondpads liegen, verkürzt ausgebildet ist.

4. Multichipmodul nach einem der Ansprüche 1 bis 3, **dadurch gekennzeichnet, dass** das Distanzstück (5) als Folie oder als Glasplättchen ausgebildet ist.

5. Multichipmodul nach einem der Ansprüche 1 bis 4, **dadurch gekennzeichnet, dass** auf dem Board (1) eine Kontaktierungsmatrix ausgebildet ist.

6. Multichipmodul nach einem der Ansprüche 1 bis 5, **dadurch gekennzeichnet, dass** die Loophöhe des Bonddrahtes (4) maximal 100 µm über der Chipoberfläche liegt.

7. Verfahren zur Herstellung von Multichipmodulen in COB Bauweise nach einem der Ansprüche 1 bis 6, insbesondere mit nichtflüchtigen Speichern, bei denen die Bondpads an der Peripherie der Chips angeordnet sind, **dadurch gekennzeichnet, dass** die als Nacktchips ausgebildeten Chips lagenweise montiert werden.

8. Verfahren nach Anspruch 7, **dadurch gekennzeichnet, dass** zunächst auf dem Board eine dünne Schicht Klebstoff aufgebracht und das erste Chip bzw. die erste Chipebene darauf befestigt wird.

9. Verfahren nach Anspruch 7 oder 8, **dadurch gekennzeichnet, dass** als Klebstoff ein isolierendes thermisch leitendes Mittel aufgebracht wird.

10. Verfahren nach einem der Ansprüche 7 bis 9, **dadurch gekennzeichnet, dass** nach der Montage der jeweiligen Chipebene das Drahtbonden in bekannter Weise durchgeführt wird.

11. Verfahren nach einem der Ansprüche 7 bis 10, **dadurch gekennzeichnet, dass** nach dem Bonden die Montage der nächsten Chipebene unter Realisierung der Sandwichanordnung erfolgt.

12. Verfahren nach einem der Ansprüche 7 bis 11, **dadurch gekennzeichnet, dass** die zweite Chipebene so aufgesetzt wird, dass zwischen beiden Chips im Padbereich ein Spalt von ca. 0,1 bis 0,2 mm gebildet wird und dass der Spalt mit einem Epoxy - Klebstoff gefüllt und ausgehärtet wird.

13. Verfahren nach einem der Ansprüche 7 bis 12, **dadurch gekennzeichnet, dass** nach jeder Chipebene und / oder nach vollständiger Montage der Chips ein Funktionstest durchgeführt wird.

14. Verfahren nach einem der Ansprüche 7 bis 13, **dadurch gekennzeichnet, dass** der Montageablauf sich n- mal wiederholt, wobei n größer 1 ist.
